(19) Europäisches Patentamt
European Patent Office
Office européen des brevets

(11)     EP 2 798 668 B1

(12)     **FASCICULE DE BREVET EUROPEEN**

(45) Date de publication et mention
de la délivrance du brevet:
**21.09.2016   Bulletin 2016/38**

(21) Numéro de dépôt: **12819117.8**

(22) Date de dépôt: **27.12.2012**

(51) Int Cl.:
*H01L 29/16* (2006.01)          *H01L 29/04* (2006.01)
*H01L 23/00* (2006.01)          *H01L 21/762* (2006.01)
*B32B 17/06* (2006.01)          *H01L 21/20* (2006.01)

(86) Numéro de dépôt international:
**PCT/FR2012/053091**

(87) Numéro de publication internationale:
**WO 2013/098530 (04.07.2013 Gazette 2013/27)**

(54) **PROCEDE DE FABRICATION D'UNE STRUCTURE MULTICOUCHE SUR UN SUPPORT**

VERFAHREN ZUR HERSTELLUNG EINER MEHRSCHICHTIGEN STRUKTUR AUF EINEM SUBSTRAT

METHOD FOR MANUFACTURING A MULTILAYER STRUCTURE ON A SUBSTRATE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **29.12.2011  FR 1162523**

(43) Date de publication de la demande:
**05.11.2014   Bulletin 2014/45**

(73) Titulaire: **Commissariat à l'Énergie Atomique
et aux Énergies Alternatives
75015 Paris (FR)**

(72) Inventeurs:
• **ROSSINI, Umberto**
**F-38500 Coublevie (FR)**
• **TEMPLIER, François**
**F-38054 Grenoble Cedex 9 (FR)**

(74) Mandataire: **Thibon, Laurent
Cabinet Beaumont
1, rue Champollion
38000 Grenoble (FR)**

(56) Documents cités:
EP-A1- 2 068 358          US-A1- 2009 061 593
US-A1- 2009 072 343

## Description

Domaine de l'invention

La présente invention concerne un procédé de fabrication d'une structure multicouche, correspondant par exemple à une plaquette de circuits intégrés, sur un support final par collage moléculaire. La présente invention concerne également un support initial pour une telle structure multicouche.

Exposé de l'art antérieur

Pour certaines applications, il est souhaitable de réaliser une plaquette de circuits intégrés sur un support. En particulier, pour des applications dans le domaine de l'optique, le support doit être isolant et transparent. Il s'agit par exemple de verre. Un exemple d'application concerne la fabrication d'un écran de visualisation transmissif.

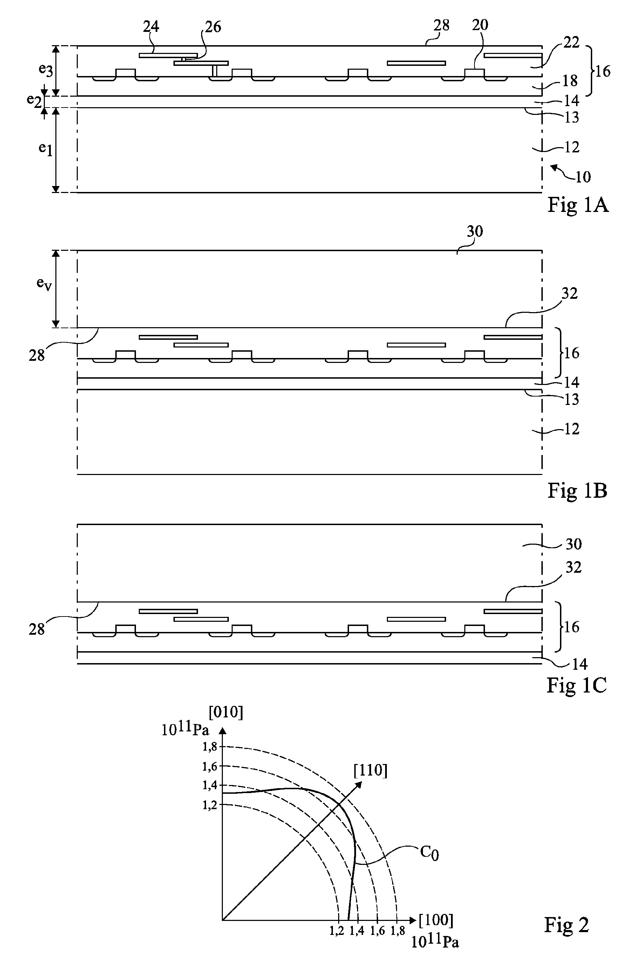

Le document US2009/072343 décrit un dispositif semi-conducteur à haute performance utilisant un substrat de silicium sur isolant (SOI) dans lequel un substrat à faible résistance thermique (en verre) est utilisé en tant que substrat de base. Les figures 1A à 1C représentent des coupes schématiques de structures obtenues à des étapes successives d'un procédé de fabrication d'une plaquette de circuits intégrés sur un support par collage moléculaire.

La figure 1A représente, de façon schématique, un élément 10 ayant une structure du type SOI (acronyme anglais pour Silicon On Insulator).

L'élément 10 comprend un support initial 12, par exemple un substrat de silicium monocristallin. L'épaisseur $e_1$ du support initial 12 est, par exemple, de plusieurs centaines de micromètres, et est, par exemple, égale à environ 700 $\mu$m. Le support initial 12 peut correspondre à un cylindre dont le diamètre est supérieur à une centaine de millimètres, et est égal, par exemple, à environ 200 mm ou 300 mm. Le support initial 12 comprend une face plane 13 recouverte d'une couche isolante 14, par exemple en dioxyde de silicium. L'épaisseur $e_2$ de la couche isolante 14 est, par exemple, de l'ordre de 1 $\mu$m. La couche isolante 14 est recouverte d'une plaquette de circuits intégrés 16. La plaquette de circuits intégrés 16 comprend un empilement de couches dans lequel sont formés des composants électroniques actifs et/ou passifs et des pistes conductrices reliant ces composants. A titre d'exemple, la plaquette de circuits intégrés 16 comprend une couche 18 d'un matériau semiconducteur, par exemple du silicium monocristallin, recouvrant la couche isolante 14 et dans et sur laquelle sont formés les composants électroniques actifs et/ou passifs, par exemple des transistors 20. La plaquette de circuits intégrés 16 comprend, en outre, un empilement de couches isolantes 22, par exemple en dioxyde de silicium, recouvrant la couche de silicium 18 et dans lequel sont formées des pistes 24 et des vias 26 d'un matériau conducteur pouvant venir au contact des composants électroniques. A titre d'exemple, l'épaisseur $e_3$ de la plaquette 16 est de l'ordre de quelques micromètres. La dernière couche isolante de l'empilement 22 de couches isolantes forme une face supérieure plane 28 opposée au support 12.

La figure 1B représente la structure obtenue après la réalisation d'un collage moléculaire entre la face 28 de l'élément 10 et un support final 30. Le support final 30 est en un matériau différent du silicium, par exemple en verre. L'épaisseur $e_v$ du support final 30 est supérieure à plusieurs centaines de micromètres, et est, par exemple, égale à environ 700 $\mu$m. Le support final 30 comprend une face 32 appliquée contre la face 28. Le collage moléculaire consiste à créer une liaison entre les faces 28 et 32 sans l'apport de matière extérieure (comme une colle ou une matière adhésive). Pour cela, les faces 28 et 32, convenablement nettoyées, sont mises au contact l'une de l'autre à température ambiante. Une pression peut être exercée localement sur le support 30 pour amorcer le collage. Le front de propagation de la zone collée se répand alors de la région d'amorce sur l'ensemble des surfaces en regard.

La figure 1C représente la structure obtenue après le retrait du support initial 12. Le retrait du support initial 12 peut comprendre une étape de rectification mécano-chimique pour retirer la plus grande partie du support initial 12 suivie d'une étape de gravure chimique sélective pour retirer le reste du support initial 12. La couche isolante 14 peut servir de couche d'arrêt lors du retrait du support initial 12.

Le procédé se poursuit généralement par la réalisation de vias conducteurs au travers de la couche isolante 14 et de la couche de silicium 18 et connectés à des pistes métalliques 24 de la plaquette de circuits intégrés 16. La formation de ces vias comprend des étapes de photolithographie, incluant des étapes dans lesquelles une couche d'une résine photosensible recouvrant la couche isolante 14 est exposée à un rayonnement au travers d'un masque pour reproduire le motif du masque sur la couche de résine. Dans ce but, le dispositif d'exposition, qui comprend notamment les systèmes optiques pour former le motif dans la couche de résine photosensible, doit être placé avec précision par rapport à la plaquette de circuits intégrés 16.

Dans un procédé de fabrication à une échelle industrielle, les étapes de photolithographie doivent être réalisées le plus rapidement possible. Dans ce but, le dispositif d'exposition est réglé au préalable pour que le motif à transférer se forme sans réglage supplémentaire de façon correcte dans la couche de résine pour une plaquette de circuits intégrés qui aurait les dimensions attendues.

Toutefois, des déformations sont observées dans la plaquette de circuits intégrés 16 après l'étape de collage.

En particulier, un rétrécissement est observé, c'est-à-dire que deux repères formés sur la face de collage 28 avant l'étape de collage sont rapprochés l'un de l'autre après l'étape de collage.

En outre, les déformations relatives observées dans la plaquette de circuits intégrés 16 dans un plan parallèle à la face 28 varient généralement selon la direction considérée. De ce fait, le rétrécissement relatif observé peut varier entre environ 16 ppm et 24 ppm selon la direction considérée, parallèlement à la face 28.

Une déformation moyenne de 20 ppm peut généralement être compensée par le dispositif d'exposition. Toutefois, il n'est pas possible de corriger, par le dispositif d'exposition, les différences de déformations relatives qui varient selon la direction considérée. De ce fait, il peut y avoir des erreurs d'alignement entre le dispositif d'exposition et la plaquette de circuits intégrés lors des étapes de photolithographie réalisées après le collage.

Un besoin existe donc d'un procédé de fabrication par collage moléculaire d'une structure multicouche, correspondant par exemple à une plaquette de circuits intégrés, sur un support final dans lequel les différences de déformations dans la plaquette de circuits intégrés qui résultent de l'opération de collage sont réduites, voire supprimées.

Résumé

Un objet de la présente invention est de proposer un procédé de fabrication d'une structure multicouche sur un support par collage moléculaire qui pallie les inconvénients des procédés connus.

Selon un autre objet de la présente invention, les différences des déformations relatives selon la direction considérée dans la plaquette de circuits intégrés qui résultent de l'opération de collage sont sensiblement supprimées.

Selon un autre objet de la présente invention, le procédé de fabrication par collage moléculaire comporte un nombre réduit d'étapes supplémentaires par rapport à un procédé de fabrication par collage moléculaire connu.

Ainsi, la présente invention prévoit un procédé de fabrication d'une structure multicouche sur un premier support en un premier matériau ayant un module d'Young $E_V$. Le procédé comprend l'utilisation d'un second support ayant une face plane recouverte de la structure multicouche, le second support étant en un second matériau ayant un module d'Young $E_S$, différent du module d'Young $E_V$, et une épaisseur $e_S$, la moyenne sur l'épaisseur $e_S$ du module d'Young $E_S$, mesuré selon n'importe quelle direction dans un plan parallèle à ladite face, étant constante à 10 % près. Le procédé comprend, en outre, le collage du premier support à la structure multicouche et le retrait du second support.

Selon un exemple de réalisation de l'invention, le second matériau est monocristallin.

Selon un exemple de réalisation de l'invention, le module d'Young $E_S$ est anisotrope.

Selon la présente invention, le second support comprend l'empilement d'un troisième support ayant une première surface plane et d'un quatrième support ayant une seconde surface plane en contact avec la première surface, les première et seconde surfaces étant parallèles à ladite face. Les première et seconde surfaces sont des surfaces cristallographiques du type (001) et la direction cristallographique [100] de la première surface est inclinée de 45° par rapport à la direction cristallographique [100] de la seconde surface.

Selon un exemple de réalisation de l'invention, le premier support a une épaisseur $e_V$ et l'épaisseur $e_S$ vérifie, à 10 % près, la relation :

$$e_S = \frac{E_V}{E_S} e_V .$$

Selon un exemple de réalisation de l'invention, le second support a initialement une épaisseur strictement supérieure à l'épaisseur $e_S$, le procédé comprenant, en outre, l'amincissement du second support jusqu'à l'épaisseur $e_S$.

Selon un exemple de réalisation de l'invention, le second matériau est du silicium monocristallin.

Selon un exemple de réalisation de l'invention, la face est une face cristallographique [111].

Selon un exemple de réalisation de l'invention, le premier matériau est du verre.

La présente invention prévoit également un support pour structure multicouche, la structure multicouche étant destinée à être collée à un support supplémentaire en un premier matériau ayant un module d'Young $E_V$, le support ayant une face plane recouverte par la structure multicouche, le support étant en un second matériau ayant un module d'Young $E_S$, différent du module d'Young $E_V$, et une épaisseur $e_S$, la moyenne sur l'épaisseur $e_S$ du module d'Young $E_S$, mesuré selon n'importe quelle direction dans un plan parallèle à ladite face, étant constante à 10 % près.

Selon un exemple de réalisation de l'invention, le support comprend l'empilement d'un troisième support ayant une première surface plane et d'un quatrième support ayant une seconde surface plane en contact avec la première surface, les première et seconde surfaces étant parallèles à ladite face. Les première et seconde surfaces sont des surfaces cristallographiques du type (001). La direction cristallographique [100] de la première surface est inclinée de 45° par rapport à la direction cristallographique [100] de la seconde surface.

Selon un exemple de réalisation de l'invention, le second matériau est du silicium monocristallin, ladite face étant une face cristallographique [111].

Selon un exemple de réalisation de l'invention, le support supplémentaire a une épaisseur $e_V$, et l'épaisseur $e_S$ vérifie, à 10 % près, la relation :

$$e_s \; = \; \frac{E_v}{E_s} \; e_v \; .$$

Brève description des dessins

Ces objets, caractéristiques et avantages, ainsi que d'autres seront exposés en détail dans la description suivante de modes de réalisation particuliers faite à titre non limitatif en relation avec les figures jointes parmi lesquelles :

les figures 1A à 1C, décrites précédemment, représentent les structures obtenues à des étapes successives d'un procédé de fabrication connu d'une plaquette de circuits intégrés sur un support isolant ; et
la figure 2 représente l'évolution du module d'Young dans un plan (100) d'un support en silicium monocristallin ;
les figures 3A à 3E représentent les structures obtenues à des étapes successives d'un exemple de réalisation d'un procédé de fabrication d'une plaquette de circuits intégrés sur un support isolant selon la présente invention ;
la figure 4 représente l'évolution du module d'Young dans un plan parallèle à la face de collage d'un support en silicium selon l'invention ; et
les figures 5A à 5F représentent les structures obtenues à des étapes successives d'un exemple de réalisation d'un procédé de fabrication d'une plaquette de circuits intégrés sur un support isolant selon la présente invention.

Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Le principe de l'invention se base sur une analyse des phénomènes physiques qui se produisent lors d'une opération de collage moléculaire de deux supports comprenant des matériaux de natures différentes. Au niveau du front de propagation de la zone collée, on observe une mise en extension locale des supports. Lorsque les modules d'Young des matériaux des supports sont différents, les déformations locales résultantes ne sont pas identiques. La face collée du support dont le module d'Young est le plus faible s'étend davantage que la face collée du support dont le module d'Young est le plus élevé. Le collage se produit alors que les supports sont déformés. Après avoir collé les deux supports et retiré l'un des supports pour ne laisser qu'une couche mince collée à l'autre support, des déformations dans la couche mince sont observées.

En général, lors du collage d'une plaquette de circuits intégrés sur un support final en verre, la plaquette de circuits intégrés repose sur un support initial, retiré par la suite, qui est un substrat de silicium monocristallin. Les inventeurs ont mis en évidence que, lors du collage moléculaire de la plaquette de circuits intégrés sur le support final, les déformations résultantes observées dans la plaquette de circuits intégrés sont essentiellement dues à la nature du matériau du support initial utilisé pour l'application de la plaquette de circuits intégrés contre le support final. En effet, l'épaisseur de la plaquette de circuits intégrés est faible par rapport à l'épaisseur du support initial et il est possible de la négliger. Le module d'Young du verre est inférieur au module d'Young du silicium de sorte que l'on observe, après le collage, un agrandissement négatif dans un plan de la plaquette de circuits intégrés parallèle aux faces collées.

Les inventeurs ont mis en évidence que les différences de déformations relatives dans la plaquette de circuits intégrés provenaient des propriétés mécaniques anisotropes du matériau formant le support initial. En particulier, les inventeurs ont mis en évidence que les différences de déformations relatives dans la plaquette de circuits intégrés étaient liées aux variations du module d'Young du matériau formant le support initial selon la direction considérée dans un plan parallèle aux faces collées.

La figure 2 représente une courbe $C_0$ d'évolution du module d'Young dans un plan cristallographique (100) du support 12 en silicium monocristallin. Le module d'Young varie entre une valeur d'environ 130 GPa pour les directions cristallographiques [100] et [010] et une valeur de 170 GPa pour la direction cristallographique [110].

Pour les structures SOI actuellement disponibles dans le commerce, la face 13 du support initial 12 en silicium correspond généralement à une face cristallographique (100). Les inventeurs ont observé que le rétrécissement relatif est de l'ordre de 16 ppm dans les directions cristallographiques [100] et [010] et est de l'ordre de 24 ppm dans la direction cristallographique [110].

Le principe de l'invention est de modifier le support initial 12 de sorte que le module d'Young du support initial soit en moyenne sensiblement uniforme indépendamment de la direction considérée dans un plan perpendiculaire aux faces collées.

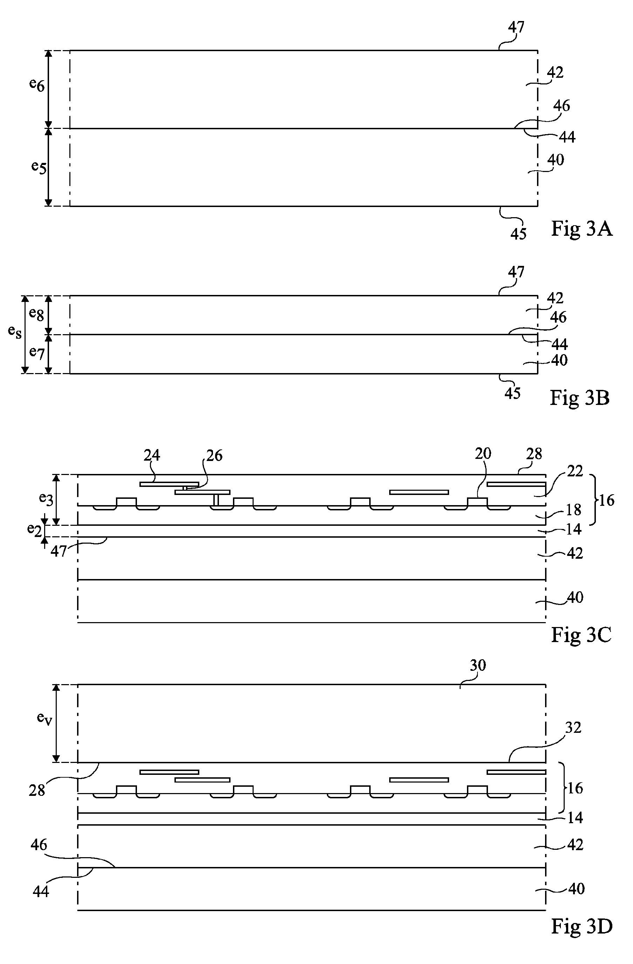

Les figures 3A à 3E représentent les structures obtenues à des étapes successives d'un premier exemple de réalisation d'un procédé de fabrication d'une plaquette de circuits intégrés sur un support isolant selon l'invention.

La figure 3A représente la structure obtenue après avoir collé deux supports 40, 42 l'un à l'autre. Le support 40 est en silicium monocristallin. Le support 40 a une épaisseur $e_5$ de plusieurs centaines de micromètres, par exemple égale à environ 700 $\mu$m. Il s'agit, par exemple, d'un substrat de silicium couramment disponible dans le commerce notamment pour la fabrication de circuits intégrés. Le support 40 comprend deux faces parallèles 44 et 45 qui correspondent chacune à une face cristallographique (100). Le support 42 est en silicium monocristallin. Le support 42 a une épaisseur $e_6$ de plusieurs centaines de micromètres, par exemple égale à environ 700 $\mu$m. Il s'agit, par exemple, d'un substrat de silicium couramment disponible dans le commerce notamment pour la fabrication de circuits intégrés. Le support 42 comprend deux faces parallèles 46 et 47 qui correspondent chacune à une face cristallographique (100). Les épaisseurs $e_5$ et $e_6$ sont égales. La face 44 du support 40 est collée à la face 46 du support 42. Le collage entre les supports 40 et 42 peut être réalisé de n'importe quelle façon. Il s'agit, par exemple, d'un collage moléculaire.

Le support 40 est orienté par rapport au support 42 de façon que dans un plan parallèle aux faces 44 et 46, la direction cristallographique [100] du support 40 soit orientée à 45° par rapport à la direction cristallographique [100] du support 42.

La figure 3B représente la structure obtenue après une étape d'amincissement de chaque support initial 40 et 42. Cette étape peut être réalisée par un procédé de rectification mécano-chimique de chaque support initial 40 et 42. L'épaisseur $e_5$ du support initial 40 est réduite jusqu'à une épaisseur $e_7$ qui peut être de l'ordre de 350 $\mu$m. L'épaisseur $e_6$ du support initial 42 est réduite jusqu'à une épaisseur $e_8$ qui peut être de l'ordre de 350 $\mu$m. Les épaisseurs $e_7$ et $e_8$ sont égales. De façon avantageuse, la somme des épaisseurs $e_7$ et $e_8$ est égale à environ 700 $\mu$m de façon à correspondre à l'épaisseur standard des substrats de silicium utilisés de façon classique dans les procédés de fabrication de circuits intégrés.

La figure 3C représente la structure obtenue après des étapes classiques de fabrication d'une structure du type SOI dans laquelle le support de la structure SOI correspond à l'empilement des supports initiaux 40 et 42. En particulier, la couche isolante 14 a été formée sur le support 42. La couche isolante 14 est recouverte de la plaquette de circuits intégrés 16.

La figure 3D représente la structure obtenue après la réalisation d'un collage moléculaire entre la face 28 de la plaquette de circuits intégrés 16 et la face 32 du support final 30. Le support final 30 est en un matériau isolant et transparent. Il s'agit par exemple de verre. Il s'agit par exemple du verre à base de borosilicate commercialisé par la société Corning sous l'appellation Eagle 2000.

De façon connue, le procédé de collage moléculaire peut comprendre des étapes de préparation des faces 28 et 32 à coller. Si besoin, un traitement peut être réalisé pour que la rugosité des faces 28 et 32 soit adaptée à la réalisation d'un collage moléculaire. Les étapes de préparation peuvent, en outre, comprendre le nettoyage des faces 28 et 32 visant à retirer la majorité des particules présentes sur les faces 28 et 32 dont le diamètre est, par exemple, supérieur à 0,2 $\mu$m. Les étapes de préparation peuvent, en outre, comprendre un traitement chimique des faces 28 et 32 pour favoriser un collage moléculaire de type hydrophile ou hydrophobe.

Le collage peut être réalisé à température ambiante. Le collage peut être amorcé en plaquant les faces 28 et 32 l'une contre l'autre et en appliquant une pression localisée sur l'un des supports. Le collage débute alors dans une zone d'amorce et un front de propagation de collage se répand depuis la zone d'amorce jusqu'à ce que la face 28 soit collée en totalité à la face 32. Lorsque les supports 30, 40 et 42 sont cylindriques, la zone d'amorce peut être prévue en région centrale des faces 28 et 32. A titre de variante, la zone d'amorce peut être située sur un bord des faces 28 et 32. Une étape de recuit peut ensuite être réalisée à une température inférieure à la température maximale autorisée pour les matériaux utilisés. Lorsque le support final 30 est en verre, le recuit peut être réalisé jusqu'à une température de 400°C à 500°C pendant une durée d'au moins 1 heure, et en général de plusieurs heures, pour augmenter l'énergie de collage.

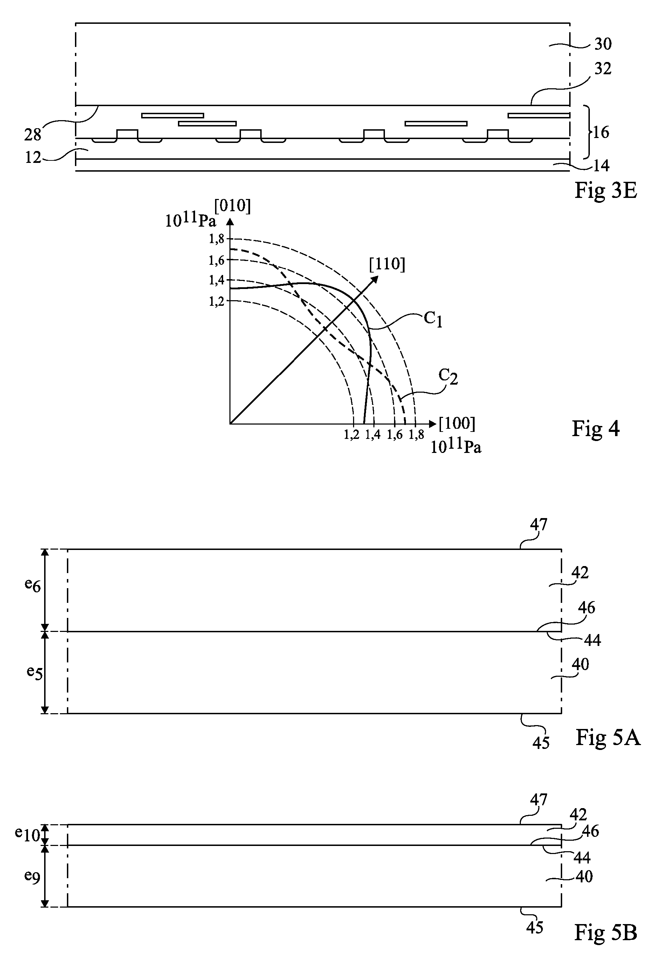

La figure 3E représente la structure obtenue après le retrait des supports initiaux 40 et 42. Le retrait des supports initiaux 40 et 42 peut comprendre une étape de rectification mécano-chimique pour retirer la plus grande partie des supports 40, 42 suivie d'une étape de gravure chimique sélective pour retirer le reste du support initial 42. La couche isolante 14 peut servir de couche d'arrêt lors du retrait des supports initiaux 40 et 42.

Le procédé se poursuit généralement par la formation de vias conducteurs au travers de la couche isolante 14 et de la couche de silicium 12.

La figure 4 représente de façon schématique des courbes d'évolution du module d'Young dans un plan parallèle aux faces 44 et 46 respectivement pour le support 40 (courbe en traits pleins $C_1$) et pour le support 42 (courbe $C_2$ en traits pointillés). Les directions cristallographiques de la face 44 étant inclinées de 45° par rapport aux directions cristallographiques de la face 46, les maximums de la courbe $C_1$ correspondent approximativement aux minimums de la courbe $C_2$. De ce fait, le module d'Young moyen de la structure constituée des deux supports 40 et 42 est sensiblement constant indépendamment de la direction considérée dans un plan perpendiculaire aux faces 44 et 46.

Selon un deuxième exemple de réalisation de l'invention, les épaisseurs des supports initiaux 40 et 42 sont choisies de façon que la plaquette de circuits intégrés 16 ne comprenne sensiblement pas de déformations après l'étape de collage. Ceci peut être avantageux dans la mesure où même si des déformations uniformes dans la plaquette de circuits intégrés 16 peuvent être généralement au moins en partie compensées par le dispositif d'exposition, ceci entraîne des étapes de réglage supplémentaires qui ne sont pas compatibles avec la réalisation d'un procédé de fabrication à une échelle industrielle.

Lors de la phase de collage entre le support final et le support initial, les énergies élastiques stockées dans chaque support sont égales, ce qui se traduit par la relation (1) suivante :

$$\frac{1}{2}\, V_v E_v \varepsilon_v \;=\; \frac{1}{2}\, V_s E_s \varepsilon_s \qquad\qquad (1)$$

où $V_V$ est le volume du support final, $V_S$ est le volume du support initial, $E_V$ est le module d'Young du support final, $E_S$ est le module d'Young du support initial, $\varepsilon_V$ est la déformation du support final et $\varepsilon_S$ est la déformation du support initial. Les modules d'Young $E_V$ et $E_S$ sont les modules d'Young mesurés dans un plan parallèle aux faces collées. Le module d'Young $E_S$ ou $E_V$ de la relation (1) peuvent correspondre à des valeurs moyennes.

Les inventeurs ont mis en évidence que lorsque les déformations $\varepsilon_V$ et $\varepsilon_S$ sont égales, cela signifie que, après collage, le support initial et le support final retrouvent un état d'équilibre sans déformation. Il est possible d'imposer que la déformation $\varepsilon_V$ dans le support final soit égale à la déformation $\varepsilon_S$ dans le support initial si les volumes $V_V$ et $V_S$ vérifient la relation (2) suivante :

$$V_v E_v \;=\; V_s E_s \qquad\qquad (2)$$

Les supports initial et final ayant la même surface en regard, la relation (2) devient la relation (3) suivante :

$$e_s \;=\; \frac{E_v}{E_s}\, e_v \qquad\qquad (3)$$

où $e_S$ est l'épaisseur du substrat initial et $e_V$ est l'épaisseur du substrat final. De façon générale, pour la formation d'une plaquette de circuits intégrés sur un support en verre, le module d'Young du support en verre est d'environ 70 GPa tandis que le module d'Young du support initial en silicium monocristallin est d'environ 140 GPa. L'épaisseur $e_S$ du support initial est alors obtenue par la relation (4) suivante :

$$e_s \approx 0{,}5 e_v \qquad\qquad (4)$$

Les figures 5A à 5E représentent les structures obtenues à des étapes successives du deuxième exemple de réalisation d'un procédé de fabrication d'une plaquette de circuits intégrés sur un support isolant selon l'invention.

La figure 5A représente une structure identique à la structure représentée en figure 3A. En particulier, le support 40 est orienté par rapport au support 42 de façon que dans un plan parallèle aux faces 44 et 46, la direction cristallographique [100] du support 40 soit orientée à 45° par rapport à la direction cristallographique [100] du support 42.

La figure 5B représente la structure obtenue après une étape d'amincissement de chaque support initial 40 et 42. Cette étape peut être réalisée par un procédé de rectification mécano-chimique de chaque support initial 40 et 42. L'épaisseur $e_5$ du support initial 40 est réduite jusqu'à une épaisseur $e_9$ qui peut être de l'ordre de 525 $\mu$m. L'épaisseur $e_6$ du support initial 42 est réduite jusqu'à une épaisseur $e_{10}$ qui peut être de l'ordre de 175 $\mu$m. Les épaisseurs $e_9$ et $e_{10}$ ne sont pas égales. De façon avantageuse, la somme des épaisseurs $e_9$ et $e_{10}$ est égale à environ 700 $\mu$m de façon à correspondre à l'épaisseur standard des substrats de silicium utilisés de façon classique dans les procédés de fabrication de circuits intégrés.

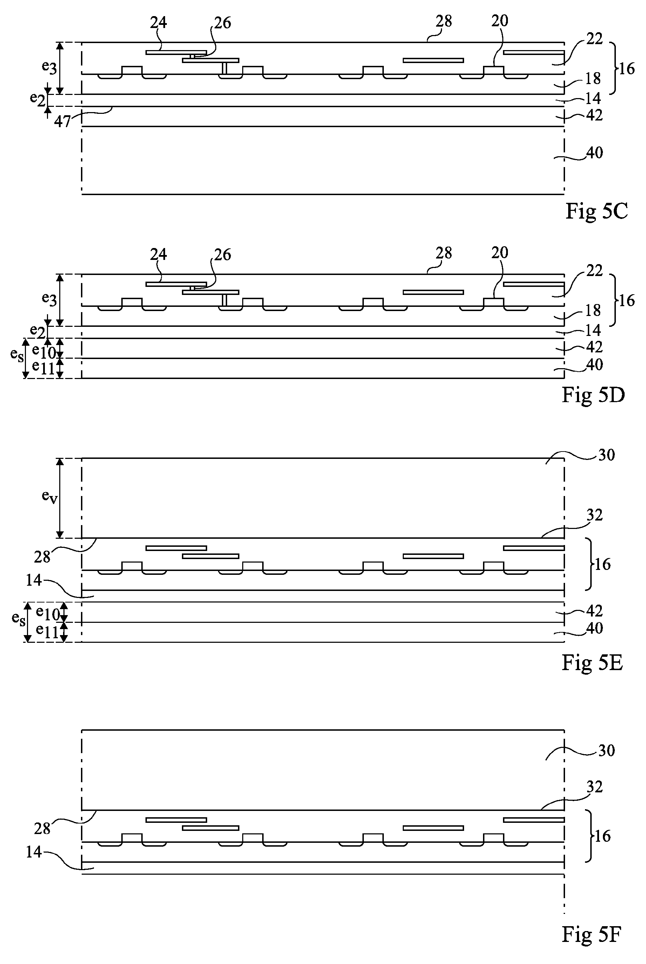

La figure 5C représente la structure obtenue après des étapes classiques de fabrication d'une structure du type SOI dans laquelle le support de la structure SOI correspond à l'empilement des supports initiaux 40 et 42. En particulier, la couche isolante 14 a été formée sur le support 42. La couche isolante 14 est recouverte de la plaquette de circuits intégrés 16.

La figure 5D représente la structure obtenue après une étape d'amincissement du support initial 40. Cette étape peut être réalisée par un procédé de rectification mécano-chimique du support initial 40. L'épaisseur $e_9$ du support initial 40 est réduite jusqu'à une épaisseur $e_{11}$ qui peut être de l'ordre de 175 $\mu$m. Les épaisseurs $e_{10}$ et $e_{11}$ sont égales.

La figure 5E représente la structure obtenue après la réalisation d'un collage moléculaire entre la face 20 de la plaquette de circuits intégrés 16 et la face 32 du support final 30 comme cela a été décrit précédemment en relation avec la figure 3D.

La figure 5F correspond à la structure obtenue après le retrait des supports initiaux 40 et 42 comme cela a été décrit précédemment en relation avec la figure 3E. Les déformations relatives dans la plaquette de circuits intégrés 16 qui résultent de l'opération de collage sont alors inférieures à 5 ppm.

Selon un troisième exemple de réalisation, le matériau formant le support initial 12 est sélectionné de façon que, dans un plan parallèle à la face de collage 28, le module d'Young du support initial 12 soit isotrope. Dans ce but, le support initial 12 en silicium monocristallin est sélectionné de façon que la face du support initial 12 recouverte de la couche isolante 14 corresponde à une face cristallographique [111]. En effet, les inventeurs ont montré que, de façon surprenante, la nature cristallographique des matériaux formant la plaquette de circuits intégrés 16 ne joue pas de rôle dans l'apparition de déformations dans la plaquette de circuits intégrés 16 lors de l'opération de collage. Seule compte la nature cristallographique du support initial 12. Dans les procédés classiques de fabrication de circuits intégrés, les supports en silicium utilisés sont des supports dont les faces externes sont des faces cristallographiques du type (100) car il s'agit du type de support en silicium dont la fabrication est la moins chère. C'est la base du troisième exemple de réalisation que d'avoir mis en évidence que l'utilisation d'un support en silicium monocristallin différent des supports en silicium monocristallin utilisés de façon classique permettait de réduire, voire de supprimer, les différences de déformations dans la plaquette de circuits intégrés.

Le troisième exemple de réalisation de procédé de fabrication d'une plaquette de circuits intégrés sur un support isolant peut comprendre les même étapes que celles décrites précédemment en relation avec les figures 1A à 1C, la seule différence étant que la face du support initial 12 recouverte de la couche isolante 14 correspond à une face cristallographique [111].

Selon une variante du troisième exemple de réalisation, l'épaisseur $e_S$ du support 12 peut, en outre, vérifier la relation (3) précédente. La plaquette de circuits intégrés 16 ne comprend alors sensiblement pas de déformations après l'étape de collage.

Des exemples de réalisation particuliers de la présente invention ont été décrits. Diverses variantes et modifications apparaîtront à l'homme de l'art. En particulier, bien que dans l'exemple de réalisation décrit précédemment, le support final soit en verre et le support initial soit en silicium, il est clair que la présente invention peut s'appliquer au collage moléculaire de tout type de matériau ayant des modules d'Young différents. A titre d'exemple, le support initial et/ou le support final peuvent être en un matériau semiconducteur, par exemple du silicium, du germanium ou de l'arséniure de gallium, en un matériau isolant, par exemple du quartz ou du saphir, ou en tout matériau à bas coût pouvant être utilisé pour réaliser un substrat poignée, par exemple un polymère.

## Revendications

1. Procédé de fabrication d'une structure multicouche (16) sur un premier support (30) en un premier matériau ayant un module d'Young $E_V$, le procédé comprenant les étapes successives suivantes :

   prévoir un second support (12 ; 40, 42) ayant une face plane (13 ; 47) recouverte de la structure multicouche, le second support étant en un second matériau ayant un module d'Young $E_S$, différent du module d'Young $E_V$, et une épaisseur $e_S$, la moyenne sur l'épaisseur $e_S$ du module d'Young $E_S$, mesuré selon n'importe quelle direction dans un plan parallèle à ladite face, étant constante à 10 % près ;
   coller le premier support à la structure multicouche ; et
   retirer le second support,

   dans lequel le second support (12 ; 40, 42) comprend l'empilement d'un troisième support (40) ayant une première surface plane (44) et d'un quatrième support (42) ayant une seconde surface plane (46) en contact avec la première surface, les première et seconde surfaces étant parallèles à ladite face, les première et seconde surfaces étant des surfaces cristallographiques du type (001) et dans lequel la direction cristallographique [100] de la première surface est inclinée de 45° par rapport à la direction cristallographique [100] de la seconde surface.

2. Procédé de fabrication selon la revendication 1, dans lequel le second matériau est monocristallin.

3. Procédé de fabrication selon la revendication 1 ou 2, dans lequel le premier support (30) a une épaisseur $e_V$ et dans lequel l'épaisseur $e_S$ vérifie, à 10 % près, la relation :

$$e_s = \frac{E_v}{E_s} e_v .$$

**4.** Procédé de fabrication selon la revendication 3, dans lequel le second support (12 ; 40, 42) a initialement une épaisseur strictement supérieure à l'épaisseur $e_S$, le procédé comprenant, en outre, l'amincissement du second support jusqu'à l'épaisseur $e_S$.

**5.** Procédé de fabrication selon l'une quelconque des revendications 1 à 4, dans lequel le second matériau est du silicium monocristallin.

**6.** Procédé de fabrication selon la revendication 5, dans lequel la face (13) est une face cristallographique [111].

**7.** Procédé de fabrication selon l'une quelconque des revendications 1 à 6, dans lequel le premier matériau est du verre.

**8.** Support (12) pour structure multicouche (16), la structure multicouche étant destinée à être collée à un support (30) supplémentaire en un premier matériau ayant un module d'Young $E_V$, le support ayant une face (13 ; 47) plane recouverte par la structure multicouche, le support étant en un second matériau ayant un module d'Young $E_S$, différent du module d'Young $E_V$, et une épaisseur $e_S$, la moyenne sur l'épaisseur $e_S$ du module d'Young $E_S$, mesuré selon n'importe quelle direction dans un plan parallèle à ladite face, étant constante à 10 % près, dans lequel le support comprend l'empilement d'un troisième support (40) ayant une première surface plane (44) et d'un quatrième support (42) ayant une seconde surface plane (46) en contact avec la première surface, les première et seconde surfaces étant parallèles à ladite face, les première et seconde surfaces étant des surfaces cristallographiques du type (001), dans lequel la direction cristallographique [100] de la première surface est inclinée de 45° par rapport à la direction cristallographique [100] de la seconde surface.

**9.** Support (12) selon la revendication 8, dans lequel le second matériau est monocristallin.

**10.** Support selon la revendication 8 ou 9, dans lequel le second matériau est du silicium monocristallin, ladite face étant une face cristallographique [111].

**11.** Support (12) selon l'une quelconque des revendications 8 à 10, dans lequel le support (30) supplémentaire a une épaisseur $e_V$, et dans lequel l'épaisseur $e_S$ vérifie, à 10 % près, la relation :

$$e_s = \frac{E_v}{E_s} e_v .$$

**Patentansprüche**

**1.** Verfahren zur Herstellung einer mehrlagigen Struktur (16) auf einem ersten Träger (30), der aus einem ersten Material mit einem E-Modul Ev gemacht ist, wobei das Verfahren die folgenden aufeinanderfolgenden Schritte aufweist:

Vorsehen eines zweiten Trägers (12; 40, 42) mit einer ebenen Fläche (13; 47), die mit der mehrlagige Struktur bedeckt ist, wobei der zweite Träger aus einem zweiten Material mit einem E-Modul Es gemacht ist, der anders ist als der E-Modul Ev, und eine Dicke $e_s$ hat, wobei der Durchschnitt des E-Modul Es über die Dicke $e_s$ gemessen entlang irgendeiner Richtung in einer Ebene parallel zu der Fläche innerhalb 10 % konstant ist;
Kleben des ersten Trägers auf die mehrlagige Struktur; und
Entfernen des zweiten Trägers,

wobei der zweite Träger (12; 40, 42) einen Stapel eines dritten Trägers (40) mit einer ersten ebenen Oberfläche (44) und eines vierten Trägers (42) mit einer zweiten ebenen Oberfläche (46) in Kontakt mit der ersten Oberfläche aufweist, wobei die ersten und zweiten Oberflächen parallel zur Fläche sind, wobei die ersten und zweiten Oberflächen Kristall- bzw. Gitterebenen des Typs (001) sind, und wobei die Kristall- bzw. Gitterrichtung [100] der ersten Oberfläche um 45° bezüglich der Gitterrichtung [100] der zweiten Oberfläche geneigt ist.

**2.** Herstellungsverfahren nach Anspruch 1, wobei das zweite Material ein ein-kristallines Material ist.

**3.** Herstellungsverfahren nach Anspruch 1 oder 2, wobei der erste Träger (30) eine Dicke $e_v$ hat, und wobei die Dicke $e_s$ innerhalb 10 % folgende Beziehung erfüllt:

$$e_s = \frac{E_v}{E_s} e_v \, .$$

**4.** Herstellungsverfahren nach Anspruch 3, wobei der zweite Träger (12; 40, 42) anfänglich eine größere Dicke als die Dicke $e_s$ hat, wobei das Verfahren weiter aufweist, den zweiten Träger auf die Dicke es dünner zu machen.

**5.** Herstellungsverfahren nach einem der Ansprüche 1 bis 4, wobei das zweite Material ein-kristallines Silizium ist.

**6.** Herstellungsverfahren nach Anspruch 5, wobei die Fläche (13) eine [111]-Gitterebene ist.

**7.** Herstellungsverfahren nach einem der Ansprüche 1 bis 6, wobei das erste Material Glas ist.

**8.** Träger (12) für eine mehrlagige Struktur (16), wobei die mehrlagige Struktur auf einen zusätzlichen Träger (30) geklebt werden soll, der aus einem ersten Material mit einem E-Modul Ev gemacht ist, wobei der Träger eine ebene Fläche (13; 47) hat, die mit der mehrlagigen Struktur bedeckt ist, wobei der Träger aus einem zweiten Material gemacht ist, der einen E-Modul Es hat, der sich von dem E-Modul Ev unterscheidet, und eine Dicke $e_s$ hat, wobei der Durchschnitt des E-Moduls Es über die Dicke $e_s$ gemessen entlang irgendeiner Richtung in einer Ebene parallel zu der Fläche innerhalb 10 % konstant ist, wobei der Träger einen Stapel eines dritten Trägers (40) mit einer ersten ebenen Oberfläche (44) und eines vierten Trägers (42) mit einer zweiten ebenen Oberfläche (46) aufweist, die in Kontakt mit der ersten Oberfläche ist, wobei die ersten und zweiten Oberflächen parallel zu der Fläche sind, wobei die ersten und zweiten Oberflächen Gitterebenen des Typs (001) sind, wobei die Gitterrichtung [100] der ersten Oberfläche um 45° bezüglich der Gitterrichtung [100] der zweiten Oberfläche geneigt ist.

**9.** Träger (12) nach Anspruch 8, wobei das zweite Material ein ein-kristallines Material ist.

**10.** Träger nach Anspruch 8 oder 9, wobei das zweite Material ein-kristallines Silizium ist, wobei die Fläche eine [111]-Gitterebene ist.

**11.** Träger (12) nach einem der Ansprüche 8-10, wobei der zusätzliche Träger (30) eine Dicke $e_v$ hat, wobei die Dicke es innerhalb 10 % folgende Beziehung erfüllt:

$$e_s = \frac{E_v}{E_s} e_v \, .$$

**Claims**

**1.** A method of manufacturing a multilayer structure (16) on a first support (30) made of a first material having a Young's modulus $E_V$, the method comprising the successive steps of:

providing a second support (12; 40, 42) having a planar face (13; 47) covered with the multilayer structure, the second support being made of a second material having a Young's modulus $E_S$, different from Young's modulus $E_V$, and a thickness $e_S$, the average of Young's modulus $E_S$ across thickness $e_S$, measured along any direction in a plane parallel to said face, being constant to within 10%;
bonding the first support to the multilayer structure; and
removing the second support,

wherein the second support (12; 40, 42) comprises a stack of a third support (40) having a first planar surface (44) and of a fourth support (42) having a second planar surface (46) in contact with the first surface, the first and second surfaces being parallel to said face, the first and second surfaces being crystallographic surfaces of type (001) and wherein the [100] crystallographic direction of the first surface is inclined by 45° with respect to the [100] crystallographic direction of the second surface.

2. The manufacturing method of claim 1, wherein the second material is a single-crystal material.

3. The manufacturing method of claim 1 or 2, wherein the first support (30) has a thickness $e_V$ and wherein thickness $e_S$ verifies, to within 10%, relation:

$$e_s = \frac{E_v}{E_s} e_v .$$

4. The manufacturing method of claim 3, wherein the second support (12; 40, 42) initially has a thickness greater than thickness $e_S$, the method further comprising thinning the second support down to thickness $e_S$.

5. The manufacturing method of any of claims 1 to 4, wherein the second material is single-crystal silicon.

6. The manufacturing method of claim 5, wherein the face (13) is a [111] crystallographic surface.

7. The manufacturing method of any of claims 1 to 6, wherein the first material is glass.

8. A support (12) for a multilayer structure (16), the multilayer structure being intended to be bonded to an additional support (30) made of a first material having a Young's modulus $E_V$, the support having a planar face (13; 47) covered with the multilayer structure, the support being made of a second material having a Young's modulus $E_S$, different from Young's modulus $E_V$, and a thickness $e_S$, the average of Young's modulus $E_S$ across thickness $e_S$, measured along any direction in a plane parallel to said face, being constant to within 10%, wherein the support comprises a stack of a third support (40) having a first planar surface (44) and of a fourth support (42) having a second planar surface (46) in contact with the first surface, the first and second surfaces being parallel to said face, the first and second surfaces being crystallographic surfaces of type (001) wherein the [100] crystallographic direction of the first surface is inclined by 45° with respect to the [100] crystallographic direction of the second surface

9. The support (12) of claim 8, wherein the second material is a single-crystal material.

10. The support of claim 8 or 9, wherein the second material is single-crystal silicon, said face being a [111] crystallographic surface.

11. The support (12) of any of claims 8 to 10, wherein the additional support (30) has a thickness $e_V$ and wherein thickness $e_S$ verifies, to within 10%, relation:

$$e_s = \frac{E_v}{E_s} e_v .$$

Fig 1A

Fig 1B

Fig 1C

Fig 2

Fig 3A

Fig 3B

Fig 3C

Fig 3D

30

32

28

16

12

14

Fig 3E

$10^{11}$Pa

[010]

1,8
1,6
1,4
1,2

[110]

$C_1$

$C_2$

1,2 1,4 1,6 1,8

[100]

$10^{11}$Pa

Fig 4

47

42

46

44

40

45

$e_6$

$e_5$

Fig 5A

47

42

46

44

40

45

$e_{10}$

$e_9$

Fig 5B

Fig 5C

Fig 5D

Fig 5E

Fig 5F

**EP 2 798 668 B1**

## RÉFÉRENCES CITÉES DANS LA DESCRIPTION

**Documents brevets cités dans la description**

- US 2009072343 A